# EUROPEAN PATENT APPLICATION

(11) **EP 3 208 835 A1**
(43) Date of publication of application: **23.08.2017**
(21) Application number: 16156336.6
(22) Date of filing: 18.02.2016
(51) Int. Cl.: H01L 21/768

(54) **SELF-ALIGNED VIA FOR INTERCONNECTS**

(71) Applicant: IMEC VZW, 3001 Leuven (BE)
(72) Inventor: BÖMMELS, Jürgen, 3001 Leuven (BE); TOKEI, Zsolt, 3001 Leuven (BE); WILSON, Chris, 3001 Leuven (BE)
(74) Representative: DenK iP

(57) **Abstract**

An interconnect structure (12) comprising:
a. a first entity (1) comprising a first set of two or more conductive lines (2) having coplanar top surfaces (5), the conductive lines (2) being separated by a first set of one or more dielectric lines (3) having coplanar top surfaces (6) positioned above the top surfaces (5) of the conductive lines (2) thereby forming dielectric ridges (4) between the conductive lines (2),
b. a first dielectric etch-stop layer (7a) overlaying the first entity (1), and
c. a low-k dielectric material (8) overlaying the first dielectric etch-stop layer (7a),
wherein a via (9) is formed through the low-k dielectric material (8) and the first dielectric etch stop layer (7a), the via (9) exposing a portion (11) of a conductive line (2), the via (9) being filled with a conductive material (18); and a method for making the same.

## Description

### Technical field of the invention

The present invention relates to the field of electrical interconnect structures and more particularly to semiconductor integrated circuits comprising such interconnect structures and to methods to manufacture the same.

### Background of the invention

In the fabrication of semiconductor circuits, and more precisely in the back end of line stage of that fabrication process, different sets of conductive lines present on different levels of the device and separated by an inter-level dielectrics must be interconnected. This interconnection typically involves the piercing of vertical interconnect access holes (i.e. via openings) through the inter-level dielectric, the via openings, once filled with a conductive material so as to formed filled via openings or simply vias, are connecting lines of one level (e.g. a lower level) with lines of the next level (e.g. a higher level). Properly aligning these vias with the conductive lines they are meant to interconnect becomes increasingly challenging as scaling advances. The misplacement of vias reducing the distance to lines that they are not meant to connect to is a key reliability limiter.

The current production of electrical interconnections in semiconductors makes use of the dual-damascene fabrication process in which via openings are formed at the bottom of trenches before to fill the via openings and the trenches with a conductive material, thereby forming a via opening filled with a conductive material (i.e. a via) and connected to a conductive line.

Methods to align a via with a conductive line situated above the via are known in the art of dual-damascene processes. An example is disclosed in US 2014/0363969 where a method is disclosed to form via openings self-aligned with a superjacent conductive line. For this purpose, a trench-first metal hard mask sequence is used wherein a first sub-lithographic trench pattern (corresponding to the set of conductive lines to be formed) is etched into a first hardmask layer. This is followed by etching a via opening into a second hardmask layer below the first hardmask layer. The via opening in the second hardmask layer may be formed by patterning a second sub-lithographic trench pattern, otherwise referred to as a via bar pattern, across and perpendicular to the first trench. After etching, the via opening in the second hardmask layer may be formed only where the first trench and the via bar pattern intersect. The via opening may be considered self-aligned in a via bar direction by the first trench pattern in the first hardmask layer. Lastly, the via pattern may be transferred from the second hardmask into an underlying substrate comprising elements to which the conductive lines should be connected by the intermediate of the via. Thereafter, both the via opening and the trenches are filled with a conductive interconnect material, thereby filling the via and forming the conductive lines. It is however to be noted that this document does not disclose how the via can be aligned with an underlying element to which the conductive lines should be connected by the intermediate of the via. Such an alignment of a via to an underlying level remains a big challenge. There is very little margin available for aligning the via with the underlying conductive line it is meant to connect.

There exists therefore a need in the art for methods permitting for methods and devices overcoming at least partly the drawbacks of the prior art.

### Summary of the invention

It is an object of the present invention to provide good methods for forming interconnect structures enabling a high tolerance to misalignment of a via with an underlying conductive line.

It is an advantage of embodiments of the present invention that a proper isolation can be provided between adjacent conductive lines.

It is an advantage of embodiments of the present invention that a large isolation distance can be provided between a via and an adjacent line not connected by this via.

The above objective is accomplished by a method and device according to the present invention.

In a first aspect, the present invention relates to a method for forming a via connected to an underlying conductive line in a semiconductor integrated circuit, comprising the steps of:
a. Providing a first entity comprising a first set of two or more conductive lines having coplanar top surfaces, the conductive lines being separated by a first set of one or more dielectric lines having coplanar top surfaces positioned above the top surface of the conductive lines thereby forming dielectric ridges between the conductive lines,
b. Overlaying the first entity with a first dielectric etch-stop layer,
c. Covering the first dielectric etch-stop layer with a low-k dielectric material, different from the material of the first dielectric etch-stop layer, the overlaying being performed in such a way that the low-k dielectric material has a flat top surface,
d. Etching a via opening in the low-k dielectric material above a portion of a conductive line until the first dielectric etch-stop layer is reached, thereby exposing a portion of the first dielectric etch-stop layer,
e. Etching selectively the portion of the first dielectric etch-stop layer with respect to the dielectric lines,by exposing the portion of a conductive line, and
f. Filling the via opening with a conductive material, thereby forming the via.

In a second aspect, the present invention relates to an interconnect structure comprising:
a. a first entity comprising a first set of two or more conductive lines having coplanar top surfaces, the conductive lines being separated by a first set of one or more dielectric lines having coplanar top surfaces positioned above the top surfaces of the conductive lines thereby forming dielectric ridges between the conductive lines,
b. a first dielectric etch-stop layer overlaying the first entity, and
c. a low-k dielectric material overlaying the first dielectric etch-stop layer,
wherein a via is formed through the low-k dielectric material and the first dielectric etch stop layer, the via contacting a portion of a conductive line, the via being formed of a via opening filled with a conductive material.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1-16 show by a series of vertically cross-sectioned perspective views, successive steps of an embodiment of the present invention.
Fig. 17 shows a schematic vertical cross-section of an interconnect structure according to the prior art.
Fig. 18 shows a schematic vertical cross-section of an interconnect structure according to an embodiment of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, when a first material is said to be etched selectively with respect to a second material, this means that the first material is etched faster than the second material. For instance, the etching process could etch the first material at least twice faster or at least five times faster or at least ten times faster than the second material. In some preferred embodiments, the second material may be substantially not etched by the etching process.

As used herein and unless provided otherwise, the term *"conformally"* means *"which follow the topography of the underlying substrate".* Conformality can be quantified as a measure of the degree to which the deposited layer conforms to the surface of a substrate. It may be expressed as a ratio of the thickness of the deposited layer measured at midpoint on the sidewalls of a trench (this corresponds in the present invention to the sidewalls of the ridge) to the thickness of the deposited layer on the bottom of the trench (this corresponds in the present invention to the top surface of a conductive lines of the first set).

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

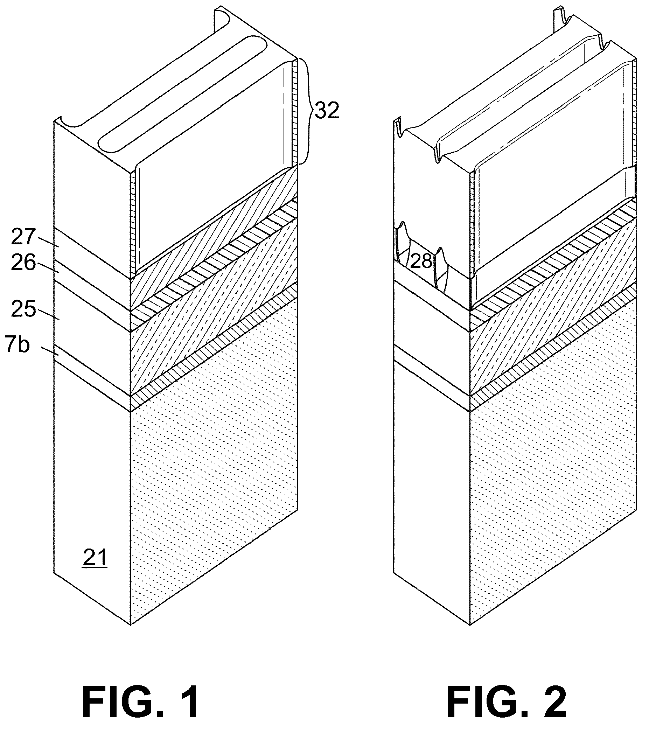

In a first aspect, the present invention relates to a method for forming a via (9') connected to an underlying conductive line (2) in a semiconductor integrated circuit. This via (9') is typically formed in a semiconductor structure (e.g. an integrated circuit) to form an interconnect structure (12), i.e. to interconnect two levels of metallization. An embodiment of the method is shown in Figs. 1 to 16.

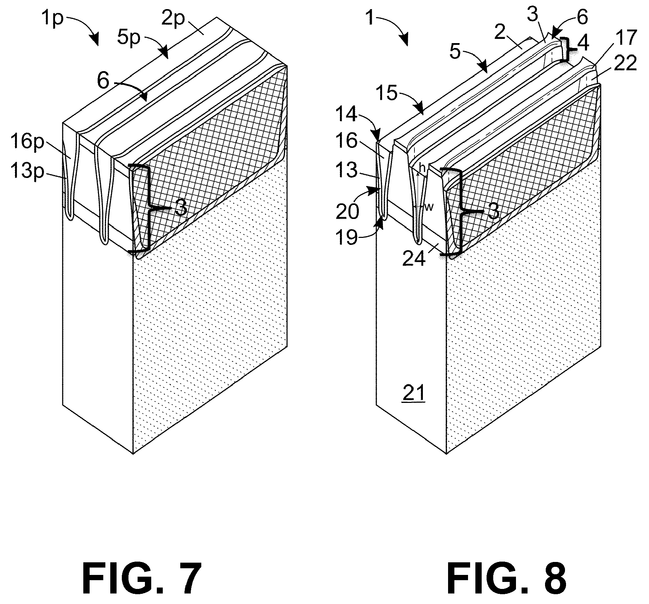

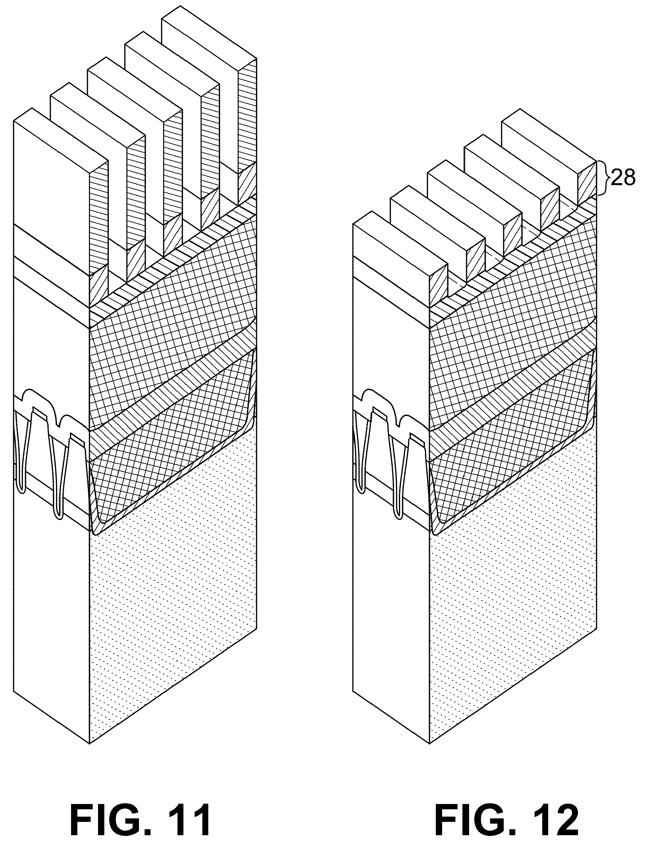

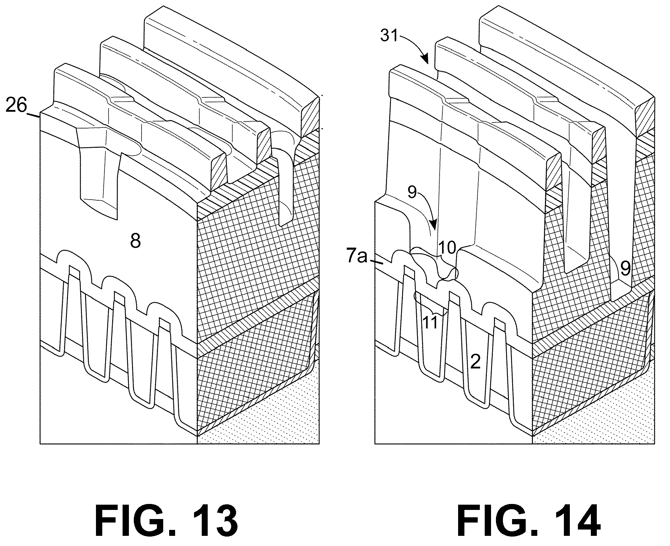

We now refer to Fig. 8 to 16 which illustrate an embodiment of the method of the first aspect. Fig. 13-16 depict steps performed on a structure analog to the structure of Fig. 12 but for a slightly different conductive line shape.

In step a, a first entity (1) is provided which comprises a first set of two or more conductive lines (2) having coplanar top surfaces (5), the conductive lines (2) being separated by a first set of one or more dielectric lines (3) having coplanar top surfaces (6) positioned above the top surface (5) of the conductive lines (2) thereby forming dielectric ridges (4) between the conductive lines (2). By *"positioned above",* it is meant that the top surfaces (6) of the one or more dielectric lines (3) is lying higher than the top surfaces (5) of the one or more conductive lines (2), e.g. the top surfaces (6) of the one or more dielectric lines (3) are farther from a substrate (21) underlying the conductive and dielectric lines (2, 3)) than the top surfaces (5) of the conductive lines (2). This is illustrated for an embodiment in Fig. 8.

Typically, the longitudinal directions of the conductive lines (2) are parallel to each other.

In any embodiment, the width (w) of the conductive lines (2) may be from 1 to 20 nm.

In any embodiment, each conductive line (2) may comprise a metal line (16) having a bottom surface (19) and side walls (20) coated with a conductive barrier layer (13). This is also illustrated for an embodiment in Fig. 8.

In any embodiment, the conductive barrier layer (13) coating the side walls (20) may have a top surface (14) coplanar with a top surface (15) of the metal line (16), wherein the top surface (14) of the conductive barrier layer (13) and the top surface (15) of the metal line (16) form together the top surface (5) of the conductive line (2). This is also illustrated for an embodiment in Fig. 8.

In any embodiment, the metal may be copper, cobalt or ruthenium. Preferably, it is copper.

Typically, when more than one dielectric line (3) is present, their longitudinal directions are parallel to each other.

In any embodiment, the dielectric lines (3) may comprise a low-k line (22). This is also illustrated for an embodiment in Fig. 8.

The low-k dielectric line (22) is more preferably an ultra-low-k dielectric line (22). The k-value of the low-k dielectric line (22) is preferably lower than 3.0 and more preferably lower than 2.6. Examples of suitable low-k materials are carbon-doped silicon dioxide and porous silicon dioxide optionally doped with carbon and/or fluorine. Ultra-low-k dielectrics have a k-value lower than 3.0 and are typically porous silicon dioxide optionally doped with carbon or fluorine.

In any embodiment, each dielectric line (3) may further comprise a cap line (17) overlaying the top of the low-k line (22), the cap line (17) being denser than the low-k line (22). This is also illustrated for an embodiment in Fig. 8.

The cap line (17) has for purpose to protect the underlying low-k dielectric line (22). This is especially useful for protecting porous low-k dielectric lines (22) such as low-k dielectric lines (22) having a k-value below 3.0 or below 2.6. Preferably, the cap line (17) is therefore made of a material denser than the underlying low-k dielectric line (22). This typically translates into a k-value higher for the cap line (17) than for the dielectric line (22). Examples of material for the cap line (17) are silicon dioxide, hydrogenated silicon oxycarbide (SiCO:H) or a bilayer SiCO:H/SiO₂ with the SiCO:H layer contacting the underlying low-k dielectric line (22).

In any embodiment, the dielectric lines (3) may optioanally further comprise a dielectric etch stop line (24) underlying the low-k line (22). This is also illustrated for an embodiment in Fig. 8.

This optional dielectric etch stop line (24) protects the substrate (21) during the formation of the dielectric lines (3). Any material which can be preserved upon etching of the dielectric layer (25) from which dielectric lines (3) will be formed can be used (see Fig. 1). It can for instance be made of silicon carbon nitride.

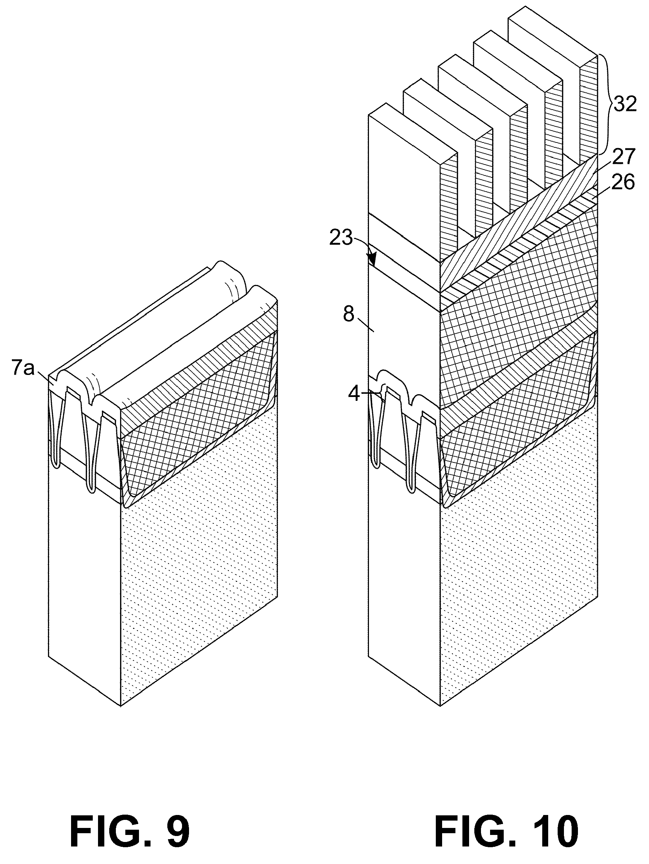

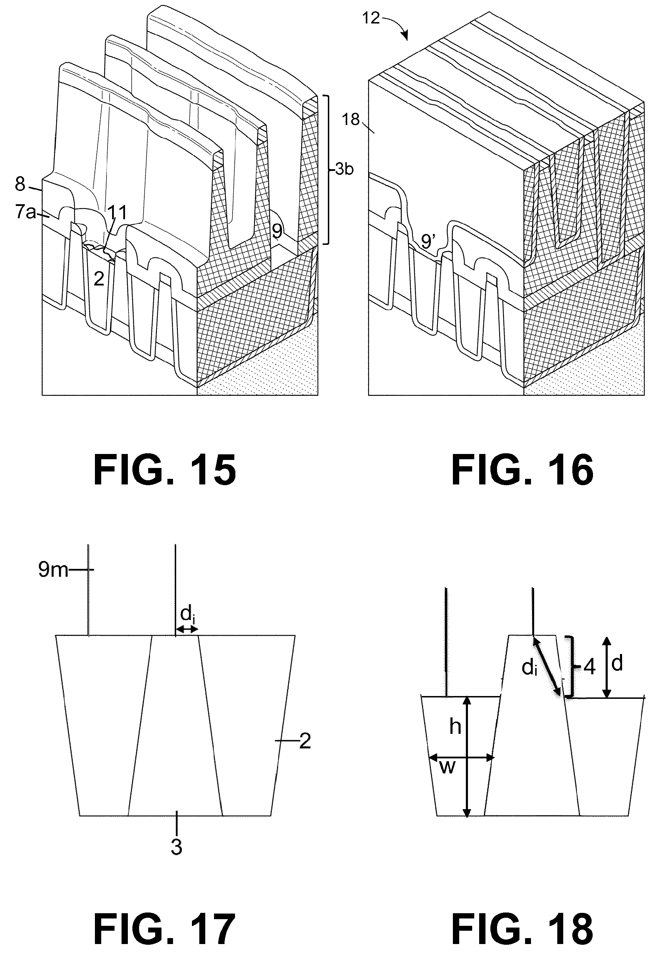

In embodiments, the conductive lines (2) may have a height (h) and a width (w) measured at mid-height, and the top surfaces (6) of the dielectric lines (3) may lie higher than the top surface (5) of the conductive lines (2) by a distance (d) (corresponding to the height of the ridges (4), see Fig. 18)) within 10%, preferably within 5% of the width (w) of the conductive lines (2) (see Figs.8 and 18). This means that, in embodiments, the distance d may be comprised between w + 10% and w - 10%, and is preferably comprised between w + 5% and w - 5%. Preferably, the top surfaces (6) of the dielectric lines (3) lies higher than the top surface (5) of the conductive lines (2) by a distance (d) equal to the width (w) of the conductive lines (2) (see Fig. 18). These embodiments are advantageous as these ranges of heights (d) for the ridges (4) are considered a good compromise between:
- improved isolation distance (dᵢ) between a via opening (9) (e.g. a misaligned via opening (9m)) and a conductive line (2) of the first set not meant to be connected with that via opening (9) (see Fig. 17 for a situation typical of the prior art wherein the isolation distance (dᵢ) is small in case of a misaligned via opening (9m) and see Fig. 18 for a situation according to an embodiment of the present invention wherein the isolation distance (dᵢ) is significantly larger in case of a misaligned via opening (9m)),
- limited topography to be compensated by the low-k dielectric material (8) (see Fig. 10), and, when this distance is obtained by recessing the conductive lines (2),
- limited increase in the resistance of the conductive lines (2).

Positive effects are however obtainable for other distances, independently of the width (w) of the conductive lines (2) of the first set. For instance, in embodiments, the top surfaces (6) of the dielectric lines (3) may lie from 1 nm to 20 nm higher than the top surface (5) of the conductive lines (2). More preferably, this distance (d) of from 1 to 20 nm may be within 10%, preferably within 5% of the width (w) and even preferably equal to the width (w) of the conductive lines (2).

In step b, the first entity (1) is overlaid with a first dielectric etch-stop layer (7a). This is illustrated for an embodiment in Fig. 9. This overlaying can be bu does not have to be conformal. Conformality is not necessary because the coating is more useful on the top surfaces (5, 6) than on the sidewalls of the dielectric lines. However, the coating can be made conformal to avoid the opposite effect, i.e. a thicker coating on the sidewalls than on the top surfaces (5, 6). In these embodiments, the conformality of the first dielectric etch-stop layer (7a) on the first entity (1) may be at least 80%.

The dielectric etch-stop layer (7a) may for instance be silicon carbon nitride (SiCN) or aluminium nitride (AIN).

In embodiments, the dielectric etch-stop layer (7a) may be deposited by Atomic Layer Deposition (ALD) or Chemical Vapor Deposition (CVD). For instance, Low-pressure chemical vapor deposition (LPCVD) or plasma enhanced chemical vapor deposition (PECVD) can be used for that purpose.

In step c, the first dielectric etch-stop layer (7a) is covered with a low-k dielectric material (8), different from the material of the first dielectric etch-stop layer (7a), the covering being performed in such a way that the low-k dielectric material (8) has a flat top surface (23). This is illustrated for an embodiment in Fig. 10.

In any embodiment, the low-k dielectric material (8) may be an ultra-low-k dielectric layer (8). The k-value of the low-k dielectric material (8) is preferably lower than 3.0 and more preferably lower than 2.6. Examples of suitable low-k materials (8) are carbon-doped silicon dioxide and porous silicon dioxide optionally doped with carbon and/or fluorine. Ultra-low-k dielectrics (8) have a k-value lower than 3.0 and are typically porous silicon dioxide optionally doped with carbon and/or fluorine.

In embodiments, the materials of the dielectric etch-stop layer (7a) and of the low- k dielectric material (8) may be selected in such a way that with a first etching method the low-k dielectric material (8) can be etched selectively with respect to the etch-stop layer (7a). In embodiments, the materials of the etch-stop layer (7a) and of the dielectric lines (3) may be selected in such a way that with a second etching method, the etch-stop layer (7a) can be etched selectively with respect to the material(s) of the dielectric lines (3). As an example, if the low-k dielectric material (8) is chosen to be porous silicon dioxide (8), if the etch-stop layer (7a) is chosen to be aluminium nitride, and if the dielectric lines (3) comprise of a porous silicon dioxide line (22) capped with a hydrogenated silicon oxycarbide cap line (17), a suitable first etching method may be a fluorine-based plasma and a suitable second etching method may be a chlorine-based plasma.

In any embodiment, obtaining the flat top surface (23) in step c may comprise a chemical mechanical planarization step of the low-k dielectric material (8). In that case the step of covering the first dielectric etch-stop layer (7a) with a low-k dielectric material (8) would comprise the sub-steps of first providing the first dielectric etch-stop layer (7a), followed by performing a CMP on the provided first dielectric etch-step layer (7a).

In embodiments, obtaining the flat top surface (23) in step c may comprise spin-coating of the low-k dielectric material (8). Spin coating being a relatively self-planarizing method, its use may, but do not have to, dispense in some embodiments from a chemical mechanical planarization step. In other embodiments, the low-k dielectric material (8) may be provided by chemical vapor deposition.

In any embodiment, obtaining the flat top surface (23) in step c may comprise providing a thickness of low-k dielectric material (8) large enough to supress in the top surface (23) of the low-k dielectric material (8) a topography induced by presence of the ridges (4). This is generally achievable independently of the method used because there will typically be a deposition thickness above which the top surface (23) of the low-k dielectric material (8) is planar. Optionally, a chemical mechanical planarization step may additionally still be performed.

In any embodiment, the thickness of low-k dielectric material (8) provided may be at least four times the height (d) of the ridges (4). This is advantageous as it is typically sufficient to assure a thickness large enough to supress in the top surface (23) of the low-k dielectric material (8) a topography induced by presence of the ridges (4). This applies for instance in the case of chemical vapor deposition.

In step d, a via opening (9) is etched in the low-k dielectric material (8) above a portion (11) of a conductive line (2) until the first dielectric etch-stop layer (7a) is reached, thereby exposing a portion (10) of the first dielectric etch-stop layer (7a). This is illustrated for an embodiment in Fig. 14. The via opening (9) is above a portion (11) of the conductive line (2). In other words, it overlaps with at least a portion of the width of the conductive line (2). The via opening (9) formed in step d can be wider or narrower than the width of the conductive line (2). The via opening (9) formed in step d can overlap with only a portion of the width of the conductive line (2) of with the whole width of the conductive line (2). When at least a further conductive line is present, the via opening (9) is preferably not above the further conductive line, i.e. it preferably does not overlap with the further conductive line. This avoids undesired cross-talks or short-circuits. In embodiments, this is ensured by etching a via opening (9) having a width smaller than the width of the dielectric line (3) separating the conductive line (2) and the further conductive line. In embodiments, the via opening (9) may be etched in the low-k dielectric material (8) above a portion (11) of a conductive line (2) and above a portion of a dielectric ridge (4), until the first dielectric etch-stop layer (7a) is reached, thereby exposing a portion of the dielectric etch-stop layer (7a).

In step e, the portion (10) of the first dielectric etch-stop layer (7a) is etched selectively with respect to the material(s) forming the dielectric lines (3) (e.g. if the etch-stop layer is made of aluminium nitride and if the dielectric lines comprise of a porous silicon dioxide line (22) capped with a hydrogenated silicon oxycarbide cap line (17), the etching could be performed with a chlorine based plasma), thereby exposing the portion (11) of a conductive line (2). This is illustrated for an embodiment in Fig. 15. In embodiments where the via opening (9) may be etched in the low-k dielectric material (8) above a portion (11) of a conductive line (2) and above a portion of a dielectric ridge (4), step e may comprise etching selectively the portion (10) of the first dielectric etch-stop layer (7a) with respect to the low-k dielectric material (8), thereby exposing the portion (11) of the conductive line (2) and further exposing a portion of the dielectric ridge (4).

In step f, the via opening (9) is filled with a conductive material (18). This is illustrated for an embodiment in Fig. 16.

In any embodiment, the method may further comprise a step d' of etching one or more trenches (31) in the low-k dielectric material (8) at an angle relative to the first set of conductive lines (2), wherein one of the trenches (31) is aligned with the via opening (9) and connected therewith. In a first alternative, step d' may overlap in time with step d by starting after that step d begins but before that step d finishes and by ending simultaneously with the ending of step d thereby forming trenches (31) in the low-k dielectric material (8) shallower than the via opening (9) wherein one of the trenches (31) connects with the exposed portion (10) of the first dielectric etch-stop layer (7a) by the intermediate of the via opening (9). This is illustrated for an embodiment in Figs. 13 to 15. In a second alternative, step d' may start after the completion of step d. In both alternatives, step f of the method may comprise filling the via opening (9) and the one or more trenches (31) with the conductive material (18). This is illustrated in Fig. 16. By *"etching one or more trenches (31) at an angle relative to the first set of conductive lines (2)",* it is meant that the conductive lines (2) are parallel to one another and have a longitudinal direction (e.g. in a plane parallel to the substrate), that the etched trench has a longitudinal direction (e.g. in a plane parallel to the substrate), and that the longitudinal direction of the etched trench (31) is at an angle relative to the longitudinal direction of the first set of conductive lines (2). In embodiments, these one or more trenches (31) may be perpendicular to the first set of conductive lines (2). This is illustrated in Fig. 14 and 15.

In embodiments, prior to etching the via opening (9), the following steps may be performed after step c and before step d (see Fig. 10). The low-k dielectric material (8) may be overlaid with a cap layer (26). The cap layer (26) has for purpose to protect the underlying low-k dielectric material (8). This is especially useful for protecting porous low-k dielectric materials (8) such as low-k dielectric materials (8) having a k-value below 3.0 or below 2.6. Preferably, the cap layer (26) is therefore made of a material denser than the underlying low-k dielectric material (8). This typically translates into a k-value higher for the cap layer (26) than for the low-k dielectric material (8). Examples of material for the cap layer (26) are silicon dioxide, hydrogenated silicon oxycarbide (SiCO:H) or a bilayer SiCO:H/SiO₂ with the SiCO:H layer contacting the underlying low-k dielectric material (8).

In embodiments where the method comprises etching one or more trenches (31), a hard mask (27) may then be provided on the cap-layer (26). The hard mask (27) may be patterned to from a set of lines (28) corresponding to the second set of dielectric lines (3b) to be formed (see Fig. 15). This is depicted for an embodiment in Fig. 11 and 12. The hard mask (27) can be made of any hard mask material such that the low-k dielectric material (8) can be etched selectively with respect to this hard mask material and can for instance be a TiN hard mask (27). The patterned hard mask (27) can be obtained as illustrated for an embodiment in Fig. 10 to 12 by first depositing a layer of hard mask material (27) on the cap layer (26), then patterning it through a patterned photoresist (32), followed by stripping of the photoresist (32). The resulting structure is illustrated for an embodiment in Fig. 12. Then, a further patterned photoresist (not depicted) comprising a pattern corresponding to the via opening (9) to be etched may be provided on the hard mask (27). Then, step d may be performed as follow. The cap layer (26) may then be opened, followed by etching of the low-k dielectric material (8) through the further patterned photoresist. This etching may be interrupted before to reach the first dielectric etch stop layer (7a). This is illustrated for an embodiment in Fig. 13. Alternatively, this etching may be continued until the first dielectric etch stop layer (7a) is reached. Then, step d' can be started.

In embodiments where the method does not comprise etching one or more trenches (31), a hard mask (not depicted) may then be provided on the cap-layer (26). The hard mask may comprise a pattern corresponding to the via opening (9) to be formed. The hard mask (not depicted) can be of any nature and can for instance be a TiN hard mask. The patterned hard mask (not depicted) can be obtained by first depositing a layer of hard mask material (27) on the cap layer (26), then patterning it through a patterned photoresist (not shown) comprising a pattern corresponding to the via opening (9) to be etched, followed by stripping of the photoresist. Then, step d may be performed as follow. The cap layer (26) may be opened, followed by etching of the low-k dielectric material (8) through the patterned hard mask.

In embodiments, providing the first entity (1) may comprise the following steps. This is illustrated for an embodiment in Fig. 7 and 8.
a1. Providing a precursor entity (1p) comprising a first set of two or more precursor conductive lines (2p) having coplanar top surfaces (5p), the precursor conductive lines (2p) being separated by the first set of one or more dielectric lines (3) having coplanar top surfaces (6), themselves being coplanar with the top surfaces (5p) of the precursor conductive lines (2p), and
a2. Recessing selectively the precursor conductive lines (2p), thereby bringing their top surfaces (5p) lower than the top surface (6) of the dielectric lines (3) thereby forming the dielectric ridges (4) between the conductive lines (2).

In embodiments, recessing selectively the precursor conductive lines (2p) may be performed in two steps: a first step of recessing selectively the precursor metal lines (16p), followed by a second step of recessing selectively the precursor conductive barrier layer (13p). For instance, if the metal is copper and the precursor conductive barrier layer (13p) is made of TaN, the first step may be a sulfuric acid wet etch and the second step may be a Cl plasma.

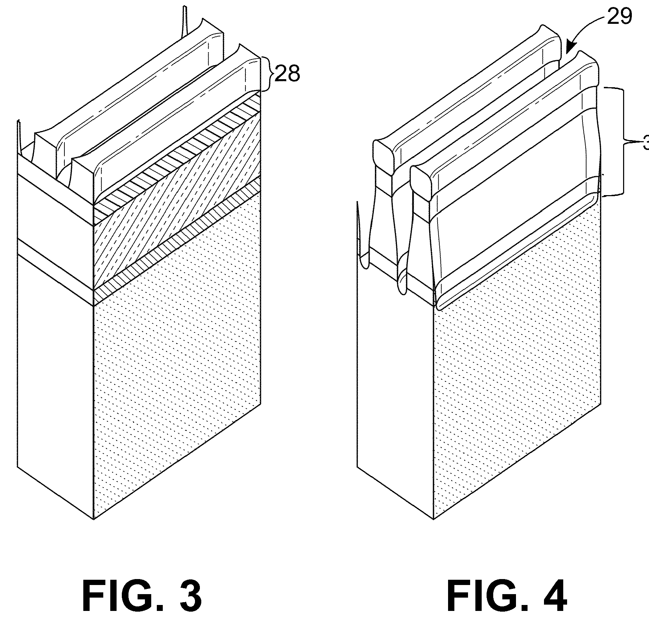

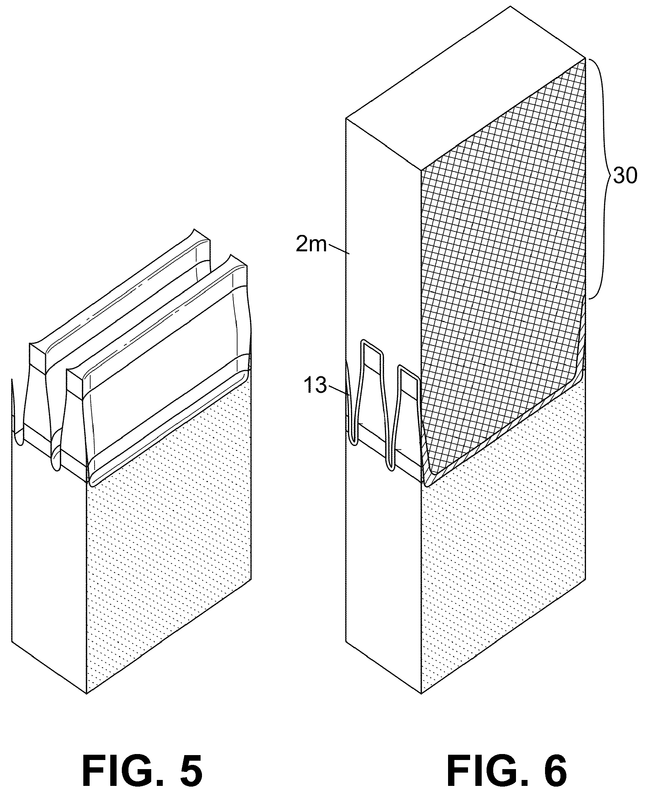

In embodiments, providing the precursor entity (1) may comprise the following steps. This is illustrated for an embodiment in Figs. 1-7.
In step i, a substrate (21) is provided. The nature of the substrate is not critical but it will typically be a semiconductor substrate (21), such as silicon, and it will typically comprise a plurality electronic components such as transistors.
In step ii, the substrate (21) is optionally overlaid with a dielectric etch stop layer (7b). This dielectric etch stop layer (7b) protects the substrate (21). Any material which can be preserved upon etching of the dielectric layer (25) can be used. Typical materials for the etch stop layer (7b) include high-k dielectric materials. These can typically relatively easily be preserved upon etching of the typical low-k materials used for the dielectric layer (25). The dielectric etch stop layer (7b) can for instance be made of silicon carbon nitride or aluminium nitride.
In step iii, the dielectric etch-stop layer (7b) is overlaid with a dielectric layer (25). The dielectric layer (25) is preferably a low-k dielectric layer and more preferably an ultra-low-k dielectric layer (25). The k-value of the dielectric layer (25) is preferably lower than 3.0 and more preferably lower than 2.6. Examples of suitable low-k materials are carbon-doped silicon dioxide and porous silicon dioxide optionally doped with carbon and/or fluorine. Ultra-low-k dielectrics have a k-value lower than 3.0 and are typically porous silicon dioxide optionally doped with carbon or fluorine.
In step iv, the dielectric layer (25) is overlaid with a cap layer (26). The cap layer has for purpose to protect the underlying dielectric layer (25). This is especially useful for protecting porous dielectric layers (25) such as dielectric layers (25) having a k-value below 3.0 or below 2.6. Preferably, the cap layer (26) is therefore made of a material denser than the underlying dielectric layer (25). This typically translates into a k-value higher for the cap layer (26) than for the dielectric layer (25). Examples of material for the cap layer (26) are silicon dioxide, hydrogenated silicon oxycarbide (SiCO:H) or a bilayer SiCO:H/SiO₂ with the SiCO:H layer contacting the underlying dielectric layer (25).
In step v, a hard mask (27) is provided on the dielectric layer (25), the hard mask (27) being patterned to form a set of lines (28) (see Fig. 2) corresponding to the first set of dielectric lines (3) to be formed. The hard mask (27) can be made of any material able to withstand the etching performed in step vi and able to be removed selectively with respect to the material(s) of the dielectric lines (3). For instance, the hard mask can be a TiN hard mask (27). The patterned hard mask (27) can be obtained by first depositing a layer of hard mask material (27) on the cap layer (26), then patterning it through a patterned photoresist (32), followed by stripping of the photoresist (32). The resulting structure is illustrated for an embodiment in Fig. 3.
In step vi, the cap layer (26), the dielectric layer (25) and the etch stop layer (7b) are etched through the patterned hard mask (27), thereby forming the dielectric lines (3) separated by voids (29) and exposing the substrate (21) between the dielectric lines (3). The resulting structure is illustrated for an embodiment in Fig.4.
In step vii, the hard mask (27) is removed. This is illustrated for an embodiment in Fig. 5. This removal, in the case of a TiN hard mask (27), the removal can be done for instance by using an aqueous solution comprising hydrogen peroxide and optionally ammonium hydroxide.
In step viii, the voids (29) between the dielectric lines (3) are filled and the dielectric lines (3) are covered with a conductive material (2m). This is illustrated for an embodiment in Fig. 6. Preferably, providing the conductive material (2m) may comprise conformally coating the structure resulting from step vi (i.e. the dielectric lines (3) and the substrate (21) exposed between them) with a conductive barrier layer (13) and covering the conductive barrier layer (13) and filling the voids between the coated dielectric lines (3) with a metal (2m). The conductive barrier layer (13) may for instance be a TaN layer. The metal may for instance be copper. The conductive barrier layer (13) is particularly useful when the metal is copper as it prevents diffusion of copper in the dielectric lines (3). The metal can for instance be provided by electroplating.
In step ix, the conductive material (2m) is planarized by removing a top portion (30) thereof in such a way as to form the precursor entity (1 p). This is illustrated in Fig. 7. This planarization can for instance be performed by chemical mechanical planarization.

It is then possible to repeat steps a to f one or more times to provide further levels of interconnections.

In a second aspect, the present invention relates to an interconnect structure (12) of the type obtainable by the method of the first aspect.

This interconnect structure (12) comprises:
a. a first entity (1) comprising a first set of two or more conductive lines (2) having coplanar top surfaces (5), the conductive lines (2) being separated by a first set of one or more dielectric lines (3) having coplanar top surfaces (6) positioned above the top surfaces (5) of the conductive lines (2) thereby forming dielectric ridges (4) between the conductive lines (2),
b. a first dielectric etch-stop layer (7a) overlaying the first entity (1), and
c. a low-k dielectric material (8) covering the first dielectric etch-stop layer (7a),
wherein a via (9') is formed through the low-k dielectric material (8) and the first dielectric etch stop layer (7a), the via (9') contacting a portion (11) of a conductive line (2), the via (9') being formed of a via opening (9) filled with a conductive material (18). This is illustrated for an embodiment in Fig. 16.

In this second aspect, the first entity (1), the first dielectric etch-stop layer (7a) and the low-k dielectric material (8) may be as defined in any embodiment of the first aspect.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

List of reference numbers:
(1 p) precursor entity
(1) first entity
(2p) precursor conductive lines of a first set
(2) conductive lines of a first set
(2m) conductive material(s) of the conductive lines
(3) dielectric lines of a first set
(3b) dielectric lines of a second set
(4) dielectric ridges
(5p) top surfaces of the precursor conductive lines
(5) top surface of the conductive lines of the first set
(6) top surface of the dielectric lines of the first set
(7a) first dielectric etch-stop layer
(7b) second dielectric etch-stop layer
(8) low-k dielectric material overlaying the dielectric etch stop
(9) via opening
(9m) misaligned via opening
(9') via
(10) portion of the dielectric etch-stop layer
(11) portion of conductive line
(12) interconnect structure
(13) conductive barrier layer
(13p) conductive barrier layer
(14) top surface of conductive barrier layer
(15) top surface of metal line
(16) metal line
(16p) precursor metal line
(17) cap line
(18) conductive material
(19) bottom surface of metal line
(20) side wall of metal line
(21) substrate
(22) low-k line
(23) top surface of the low-k dielectric material (8)
(24) dielectric etch stop line
(25) dielectric layer
(26) cap layer
(27) hard mask
(28) line of the hard mask
(29) voids
(30) top portion of conductive material (2m)
(31) trenches
(32) photoresist

## Claims

1. A method for forming a via (9') connected to an underlying conductive line (2) in a semiconductor integrated circuit, comprising the steps of:
a. Providing a first entity (1) comprising a first set of two or more conductive lines (2) having coplanar top surfaces (5), the conductive lines (2) being separated by a first set of one or more dielectric lines (3) having coplanar top surfaces (6) positioned above the top surface (5) of the conductive lines (2) thereby forming dielectric ridges (4) between the conductive lines (2),
b. Overlaying the first entity (1) with a first dielectric etch-stop layer (7a),
c. Covering the first dielectric etch-stop layer (7a) with a low-k dielectric material (8), different from the material of the first dielectric etch-stop layer (7a), the overlaying being performed in such a way that the low-k dielectric material (8) has a flat top surface (23),
d. Etching a via opening (9) in the low-k dielectric material (8) above a portion (11) of a conductive line (2) until the first dielectric etch-stop layer (7a) is reached, thereby exposing a portion (10) of the first dielectric etch-stop layer (7a),
e. Etching selectively the portion (10) of the first dielectric etch-stop layer (7a) with respect to the dielectric lines (3), thereby exposing the portion (11) of the conductive line (2), and
f. Filling the via opening (9) with a conductive material (18).

2. The method according to claim 1, wherein each conductive line (2) comprises a metal line (16) having a bottom surface (19) and side walls (20) coated with a conductive barrier layer (13) having a top surface (14) coplanar with top surface (15) of the metal line (16), wherein the top surface (14) of the conductive barrier layer (13) and the top surface (15) of the metal line (16) form together the top surface (5) of the conductive line (2).

3. The method according to claim 2 wherein the metal is copper.

4. The method according to any one of the preceding claims, wherein the dielectric lines (3) comprise a low-k line (22), and wherein each dielectric line (3) further comprise a cap line (17) overlaying the top of the low-k line (22), the cap line (17) being denser than the low-k line (22).

5. The method according to claim 4, wherein the dielectric lines (3) further comprise a second dielectric etch stop line (7b) underlying the low-k line (22).

6. The method according to any one of the preceding claims, wherein obtaining the flat top surface (23) in step c comprises providing a thickness of low-k dielectric material (8) large enough to supress in the low-k dielectric material (8) a topography induced by presence of the ridges (4).

7. The method according to claim 6 wherein the ridges (4) have a height (d) and the thickness of low-k dielectric material (8) provided is at least four times the height (d) of the ridges (4).

8. The method according to any one of the preceding claims, wherein the top surfaces (6) of the dielectric lines (3) lie from 1 nm to 20 nm higher than the top surface (5) of the conductive lines (2).

9. The method according to any one of the preceding claims, wherein the conductive lines have a height (h) and a width (w) measured at mid-height, and wherein the top surfaces (6) of the dielectric lines (3) lie higher than the top surface (5) of the conductive lines (2) by a distance (d) within 10% of the conductive lines (2).

10. The method according to any one of the preceding claims, wherein providing the first entity (1) comprises the steps of:
a1. Providing a precursor entity (1p) comprising a first set of two or more precursor conductive lines (2p) having coplanar top surfaces (5p), the precursor conductive lines (2p) being separated by the first set of one or more dielectric lines (3) having coplanar top surfaces (6), themselves being coplanar with the top surfaces (5p) of the precursor conductive lines (2p), and
a2. Recessing selectively the precursor conductive lines (2p), thereby bringing their top surfaces (5p) lower than the top surface (6) of the dielectric lines (3) thereby forming the dielectric ridges (4) between the conductive lines (2).

11. The method according to claim 10, wherein providing the precursor entity (1) comprises the steps of:
i. Providing a substrate (21),
ii. Overlaying the substrate (21) with a dielectric etch stop layer (7b),
iii. Overlaying the dielectric etch-stop layer (7b) with a dielectric layer (25),
iv. Overlaying the dielectric layer (25) with a cap layer (26),
v. Providing a hard mask (27) on the dielectric layer (25), the hard mask (27) being patterned to form a set of lines (28) corresponding to the first set of dielectric lines (3) to be formed,
vi. Etching the cap layer (26), the dielectric layer (25) and the etch stop layer (7b) through the patterned hard mask (27), thereby forming the dielectric lines (3) separated by voids (29) and exposing the substrate (21) between the dielectric lines (3),
vii. Removing the hard mask (27),
viii. Filling the voids (29) between the dielectric lines (3) and covering the dielectric lines (3) with a conductive material (2m),
ix. Planarizing the conductive material (2m) by removing a top portion (30) thereof in such a way as to form the precursor entity (1 p).

12. The method according to any one of the preceding claims wherein the the first dielectric etch-stop layer (7a) on the first entity (1) has a conformality of at least 80%.

13. The method according to any one of the preceding claims, further comprising a step d' of etching one or more trenches (31) at an angle relative to the first set of conductive lines (2), wherein one of the trenches (31) is aligned with the via opening (9) and connected therewith, wherein step d' overlaps in time with step d by starting after that step d begins but before that step d finishes and by ending simultaneously with the ending of step d thereby forming trenches (31) shallower than the via opening (9) wherein one of the trenches (31) connects with the exposed portion (10) of the first dielectric etch-stop layer (7a) by the intermediate of the via opening (9), and wherein step f of filling the via opening (9) is a step f of filling the via opening (9) and the one or more trenches (31) with the conductive material (18).

14. The method according to claim 13 wherein the one or more trenches (31) are perpendicular to the first set of conductive lines (2).

15. An interconnect structure (12) comprising:
a. a first entity (1) comprising a first set of two or more conductive lines (2) having coplanar top surfaces (5), the conductive lines (2) being separated by a first set of one or more dielectric lines (3) having coplanar top surfaces (6) positioned above the top surfaces (5) of the conductive lines (2) thereby forming dielectric ridges (4) between the conductive lines (2),
b. a first dielectric etch-stop layer (7a) overlaying the first entity (1), and
c. a low-k dielectric material (8) covering the first dielectric etch-stop layer (7a),
wherein a via (9') is formed through the low-k dielectric material (8) and the first dielectric etch stop layer (7a), the via (9') contacting a portion (11) of a conductive line (2), the via (9') being formed of a via opening (9) filled with a conductive material (18).
